# EUROPEAN PATENT APPLICATION

(11) **EP 2 339 641 A2**
(43) Date of publication of application: **29.06.2011**
(21) Application number: 10172010.0
(22) Date of filing: 05.08.2010
(51) Int. Cl.: H01L 31/0336, H01L 31/18

(54) **Compound semiconductor thin film solar cell, method of manufacturing a compound semiconductor thin film solar cell and module**

(30) Priority: 28.12.2009 JP 2009296692; 15.06.2010 JP 2010135673
(71) Applicant: Hitachi Ltd., Tokyo (JP)
(72) Inventor: Kusunoki, Toshiaki, Tokyo 100-8220 (JP); Sagawa, Masakazu, Tokyo 100-8220 (JP); Komatsu, Masaaki, Tokyo 100-8220 (JP)
(74) Representative: Beetz & Partner

(57) **Abstract**

As an n-type buffer layer (4), a material including TiO₂ as a base material with addition of one or plurality of ZrO₂, HfO₂, GeO₂, BaTiO₃, SrTiO₃, CaTiO₃, MgTiO₃, K (Ta, Nb)O₃, and Na(Ta, Nb)O₃ for band gap control, a material including BaTiO₃ as a base material with addition of one or plurality of SrTiO₃, CaTiO₃, and MgTiO₃ for band gap control, or a material comprising K (Ta, Nb)O₃ as a base material with addition of Na(Ta, Nb)O₃ for band gap control is used.

## Description

### FIELD OF THE INVENTION

The present invention concerns a technique which is effective for improving the performance of a compound thin film solar cell.

### BACKGROUND OF THE INVENTION

Compound thin film solar cells include those using, for example, a CuInSe₂ type compound belonging to the I-III-VI₂ group, a CdTe type compound belonging to the II-VI group, and a Cu₂ZnSnS₄ type compound belonging to the I₂-II-IV-VI₄ group. Among them, the cell using the CuInSe₂ type compound belonging to the I-III-VI₂ group is a compound thin film solar cell capable of obtaining the highest energy conversion efficiency at present and attains a high energy conversion efficiency of about 20% in a small area.

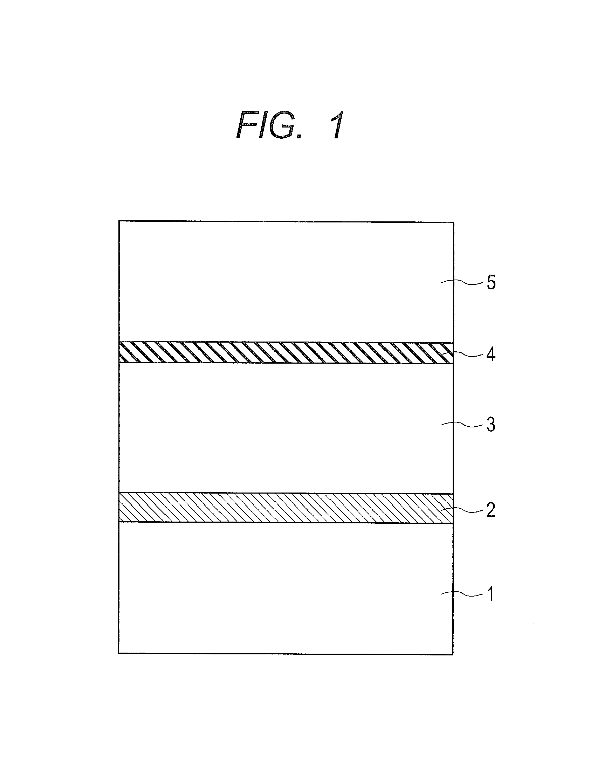

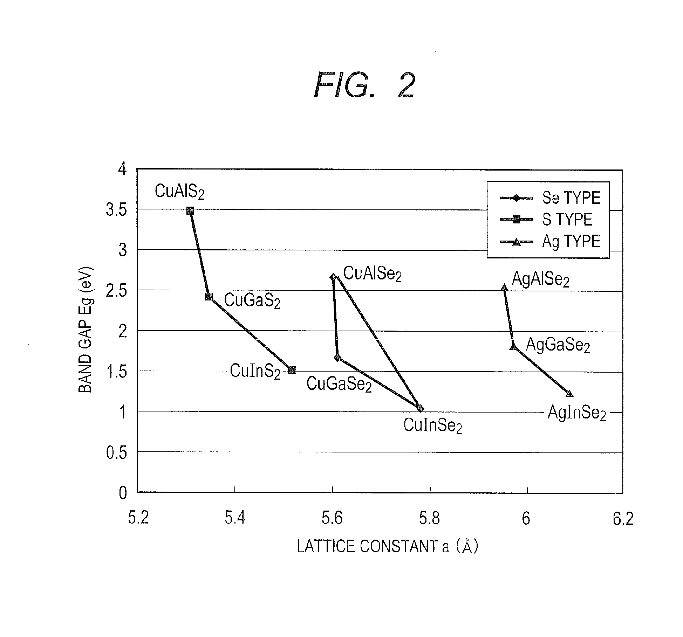

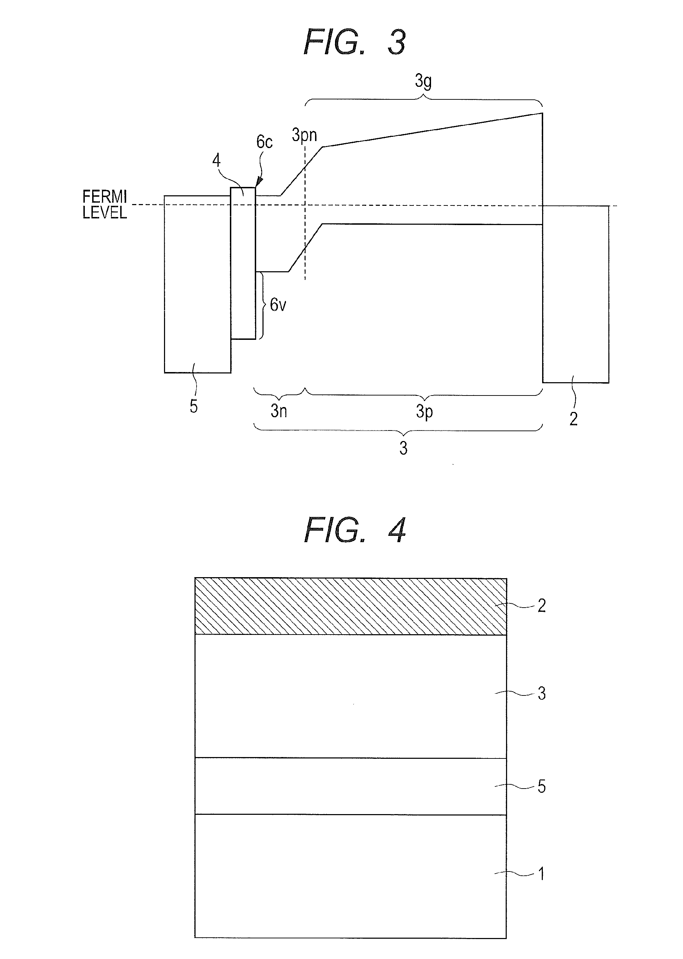

Fig. 1 shows a basic structure of a compound thin film solar cell using the CuInSe₂ type compound belonging to the I-III-VI₂ group. A soda lime substrate is usually used for a substrate 1. This is because Na precipitating from the substrate 1 has an effect of improving the crystallinity, etc. of an absorption layer 3 and improving the energy conversion efficiency (Na effect). Mo is generally used for a back electrode 2. A compound semiconductor having a chalcopyrite type crystal structure typically represented by CuInSe₂ is used for the absorption layer 3. As shown in Fig. 2, the semiconductor compound may be replaced or partially substituted for the ingredient Cu by Ag, in In by Ga or Al, and Se by S or Te, thereby capable of controlling the lattice constant and the band gap. For example, the band gap is widened by partially substituting In by Ga or Al or partially substituting Se by S. It has been known that diffusion of excited electrons to the back electrode 2 can be suppressed to improve the energy conversion efficiency by modifying the absorption layer 3 to Cu(In, Ga)Se₂ of higher Ga compositional ratio to the back electrode 2 thereby forming a graded structure having a band gap which is widened toward the back electrode 2 by utilizing the band gap controlling function as shown in the band structural view of Fig. 3. Further, band gap of the absorption layer 3 capable of absorbing a solar cell energy and performing photoelectronic conversion most efficiently is 1.4 eV in a case of a unijunction solar cell and 1.75 eV in a case of a top cell of a double junction solar cell, and studies has the now been proceeded for widening the gap of the absorption layer for improving the efficiency.

As a method of preparing the absorption layer 3, a gas phase selenization method of forming a metal thin film by deposition as a precursor by sputtering or vapor deposition, and converting the precursor film into an Se compound by annealing in a hydrogenated Se atmosphere at a high temperature of 500°C or higher is generally used.

Above the absorption layer 3, an n-type buffer layer 4 and a transparent electrode 5 are formed. As the buffer layer 4, an n-type semiconductor thin film comprising CdS (refer to USP No. 4611091), ZnS (refer to JP-A-Hei 8(1996)-330614, ZnO (refer to JP-A-2006-147759), etc, formed by a CBD (Chemical Bath Deposition) method, that is, a deposition method in a solution is used. As the transparent electrode, ITO or ZnO with addition of Al, Ga, or B is used

### SUMMARY OF THE INVENTION

The n-type buffer layer 4 at first has a function of forming a pn heterojunction with the absorption layer 3 such as CuInSe₂ as a p-type semiconductor, or diffusing bivalent element ions such as of Cd or Zn as a constituent ingredient into the absorption layer 3 comprising CuInSe₂, etc. and substituting Cu sites of monovalent element ions to transform the surface of the absorption layer 3 comprising CuInSe₂, etc. into an n-type CuInSe₂ 3n and forming a pn homojunction in the absorption layer 3 such as of CuInSe₂ by junction with a p-type CuInSe₂ 3p, thereby forming a charge separation portion 3pn of the solar cell as shown in Fig. 3. Further the buffer layer 4 has a second function of insulation of preventing direct contact between the absorption layer 3 and the transparent electrode 5 thereby decreasing a component of shunting leak. In this case, it is described that electrons excited in the conduction band of the absorption layer 3 by light absorption do not form an energy barrier upon diffusion to the transparent electrode 5 by the electric field of the pn junction and, on the other hand, necessary that holes generated in the valence band of the absorption layer 3 by light absorption diffuse toward the transparent electrode 5 and form a high energy barrier such that they are not re-combined with electrons as major carriers of the n-type transparent electrode 5, thereby turning back the holes. Therefore, it is necessary to provide a band structure in which the band offset of the conduction band (energy level difference) 6c is as small as about 0 to +0.4 eV, whereas the band offset of the valence band (energy level difference) 6v is as great as several eV between the n-type buffer layer 4 and the absorption layer 3. Further, the buffer layer 4 has a third function as a window layer of in-taking light into the absorption layer 3. It is described that the band offset of the conduction band (energy level difference) 6c is preferably as small as about 0 to +0.4 eV in "Recent development of thin film compound semiconductor photovoltaic cells ", p81 (Published from CMC, on June 30, 2007).

As the buffer layer 4, CdS, ZnS, ZnO, etc. formed by a CBD (Chemical Bath Deposition) method as a deposition method in a solution has been used so far. CdS is a material that has been used most frequently so far and has a feature capable of attaining high energy conversion efficiency because diffusion of bivalent Cd is effective as a dopant upon forming a pn homojunction, matching between the CdS conduction band position and the CuInSe₂ conduction band position is favorable, and the conduction band offset 6c is small. However, this involves a problem that toxic Cd is used, the band gap of CdS is as narrow as about 2.4 eV, and transmittance is not on the side of short wavelength of the solar spectrum. On the other hand, ZnS or ZnO is a material which has been started to be used generally instead of CdS since noxious Cd is not used. However, in the case, for example, of ZnO, since the conduction band position is lower than the conduction band position of CuInSe₂ and the band offset of the conduction band 6c is negative tending to lower the open circuit voltage, the output voltage tends to be lowered and the efficiency is somewhat lowered compared with the case of using CdS. Then, it has been attempted to add MgO to ZnO thereby widening the band gap and controlling the band offset 6c of the conduction band offset 6c. However, since the crystal structure is different between Wurtzite type ZnO and rock-salt type MgO, it also involves problems that the MgO concentration for providing mixed ZnMgO crystals is restricted and the band gap changes discontinuously at the concentration of MgO exceeding the solid solubility and the control range is narrowed.

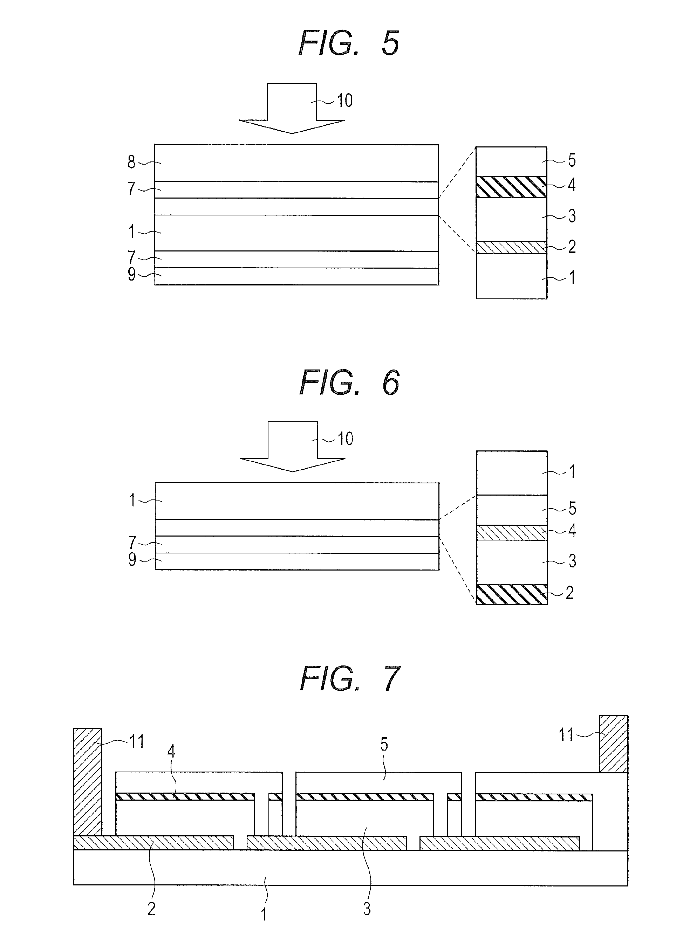

Accordingly, for the materials described above, while the conduction band offset can be matched to CuIn₀.₈Ga₀.₂Se₂ having the band gap of 1.2 eV used mainly at present, they are difficult to cope with the wide gap absorption layer having a band gap of 1.4 to 1.75 eV which have now been under development. Further, as a problem in common with CdS, ZnS, and ZnO, heat resistance is low. At present, a CBD (Chemical Bath Deposition) method of deposition in a solution at a temperature of about room temperature to 80°C is used as the production method. However, when heating is carried out at 500°C or higher which is a annealing temperature for crystallization of CuInSe₂, Cd or Zn diffuses deeply into the absorption layer 3, by which a charge separation portion 3pn is formed at a deep position where light cannot arrive from the surface or the absorption layer 3 is entirely transformed into the n-type and the charge separation portion 3pn itself can no more be formed. Therefore, the current CuInSe₂ type solar cell has a substrate structure as shown Fig. 1, obtained by forming an Mo back electrode 2 on the side of a glass substrate 1, annealing is performed previously in a state of depositing a precursor of the absorption film 3, thereby crystallizing CuInSe₂, and then forming the buffer layer 4 and the transparent electrode 5 subsequently. This is a structure contrary to the superstrate structure of an amorphous Si thin film solar cell or a CdTe compound thin film solar cell as showing in Fig. 4 of forming a transparent electrode 5 on a glass substrate 1 previously and then forming an absorption layer 3 and a back electrode 2. As shown in Fig. 5, since the solar cell module of the substrate structure requires a cover glass 8 for protection on the side of the transparent electrode 5, it has a laminated glass structure of using two sheets of glass including the glass substrate 1 by way of a sealing resin 7 and involves a problem of using more number of sheets of glass and in decreasing the cost compared with the superstrate structure in which the glass substrate 1 also serves as the cover glass 8 adopted in an amorphous Si thin film solar cell as shown in Fig. 6.

Further, the CBD (Chemical Bath Deposition) method which is an existent production method for CdS, ZnS, or ZnO of the buffer layer 4 is a solution process and, since the constitution of apparatus is greatly different from that of the dry process such as sputtering as another method of forming the back electrode 2, the absorption layer 3, and the transparent electrode 5, this results in a problem that the entire process lacks in consistently, throughput during mass production is difficult to be improved to increase the cost.

The present invention intends to overcome the problems of the buffer 4 layer described above and provide a novel material for the buffer layer 4 with no toxicity, providing good matching for energy level between the conduction band offset 6c relative to the absorption layer 3, having good insulation property, a wide band gap, high transmittance for solar spectrum, and high heat resistance, as well as a highly efficient and inexpensive compound thin film solar cell and module using the material.

This object is achieved by a compound thin film solar cell, a compound thin film solar cell module and by a method for manufacturing the latter according to the independent claims.

Some important features of typical inventions among those disclosed in the present application will be briefly described below. That is, a solar cell and a solar cell module of a CuInSe₂ type as preferred embodiments of the invention can be attained by using TiO₂ as a base material with addition of ZrO₂, HfO₂, or GeO₂ for band gap control, BaTiO₃ as a base material with addition of SrTiO₃, CaTiO₃ or MgTiO₃ for band gap control, K(Ta, Nb)O₃ as a base material with addition of Na(Ta, Nb)O₃ for band gap control or TiO₂ described above as a base material in combination with one or plurality of BaTiO₃ type and K(Ta, Nb)O₃ type as an additive material for the n-type buffer layer. A solar cell module in another embodiment of the invention can be attained by using a superstrate type CuInSe₂ type solar cell module that uses the buffer layer material in the embodiment described above and a glass substrate is situated on the light incident side.

Effects obtained by typical inventions among those disclosed in the present application are briefly described as below.

That is, the invention can provide a material for the buffer layer 4 with no toxicity, providing good matching of the conduction band offset 6c relative to the absorption layer 3, and having good insulation property, a wide band gap, and high transmittance of the solar spectrum. Further, the dry type deposition process can be used throughout the steps of forming a compound thin film solar cell, and an inexpensive CuInSe₂ type compound thin film solar cell module of the superstrate structure in which the glass substrate also serves as the cover glass can be provided.

### BRIEF DESCRIPTION OF THE DRAWINGS

Fig. 1 is a view showing a structure of a general CuInSe₂ type compound thin film solar cell;
Fig. 2 is a view showing a relation between materials of I-III-VI₂ group compounds thin film, and a lattice constant and a band gap;
Fig. 3 is a graph showing the band structure of a general CuInSe₂ type compound thin film solar cell,
Fig. 4 is a view showing an example of a structure of a superstrate type thin film solar cell;
Fig. 5 is a view showing an example of a substrate type module structure of a compound thin film solar cell;
Fig. 6 is a view showing an example of a superstrate type module structure of a compound thin film solar cell;
Fig. 7 is a schematic view of a compound thin film solar cell of a substrate structure;
Fig. 8A is a view showing an example of a flow chart for a gas phase selenization process of a compound thin film solar cell of a substrate structure;
Fig. 8B is a view showing an example of a flow chart for a solid phase selenization process of a compound thin film solar cell of a substrate structure;
Fig. 9 is a view showing examples of band structures and additive materials of buffer layer materials;
Fig. 10 is a graph showing a relation between an addition concentration of GeO₂, ZrO₂, and HfO₂ to TiO₂, and a band gap of a buffer layer;
Fig. 11 is a graph showing the result of measuring the change of a band gap upon addition of ZrO₂ to TiO₂;
Fig. 12 is a schematic view of a band structure between a TiO₂ type buffer layer and a Cu(In, Ga)Se₂ type absorption layer;
Fig. 13 is a graph showing the result of measuring the concentration of Zn, Ti, and Mg in Cu(In, Ga)Se₂ prepared by solid phase selenization by SIMS (Secondary Ion Mass Spectroscopy);
Fig. 14 is a graph showing X-ray diffraction peak intensity of Cu(In, Ga)Se₂ crystals annealed at 400°C and 550°C;
Fig. 15 is a schematic view of a compound thin film solar cell of a superstrate structure;
Fig. 16A is a view showing an example of a flow for a gas phase selenization process of a compound thin film solar cell of a superstrate structure;
Fig. 16B is a view showing an example of a flow for a solid phase selenization process of a compound thin film solar cell of a superstrate structure; and
Fig. 17 is a view showing an example of the performance of a solar cell in a case where the buffer layer contains TiO₂ and in a case where TiO₂ is substituted by addition of 10% Nb.

### DETAILED DESCRIPTION OF THE PREFERRED EMBODIMENTS

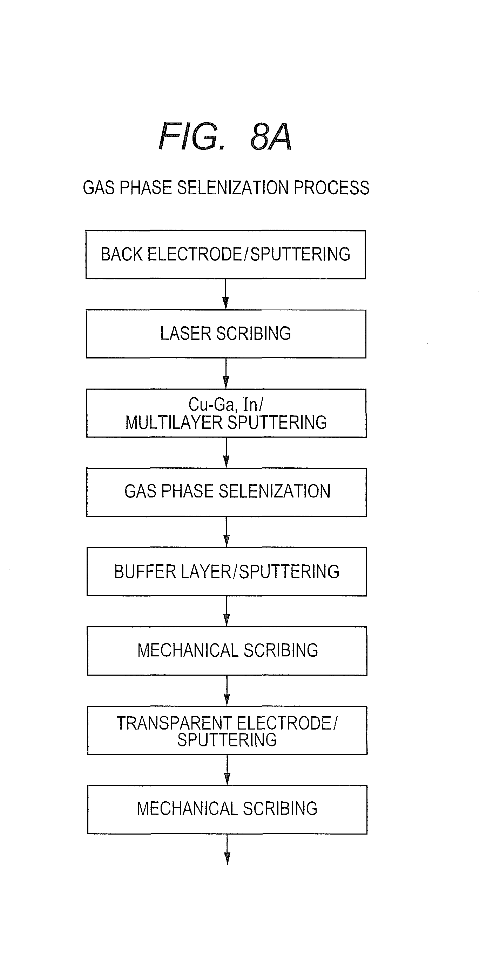

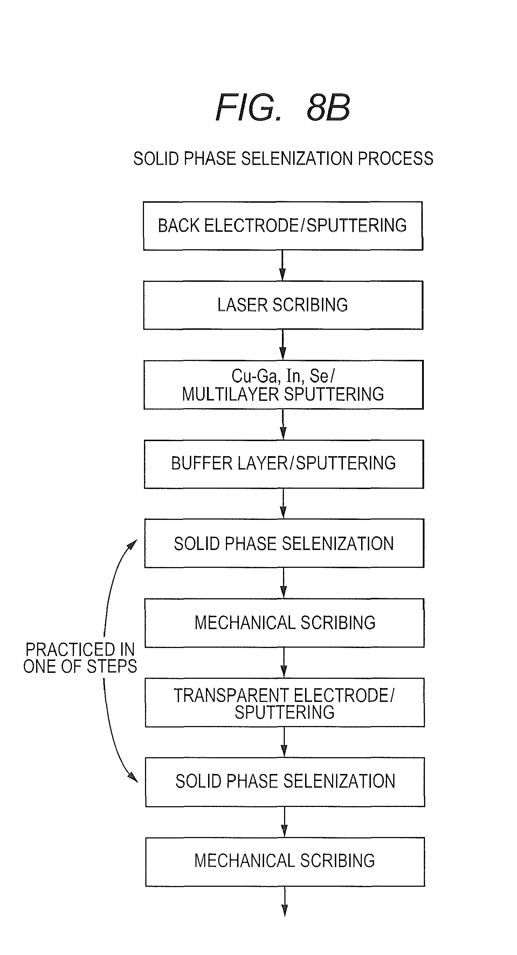

A first embodiment of the present invention is to be described specifically with reference to the drawings. The first embodiment shows an example of forming compound thin film solar cell and module of a substrate structure. Fig. 7 shows a schematic view of a compound thin film solar cell of a substrate structure, and Figs. 8A and 8B show process flow charts. At first, Mo back electrode 2 is deposited by a sputtering method above a soda lime glass type glass substrate 1. The thickness of the Mo film is about 300 nm. Then, the Mo film is fabricated into a rectangular shape by using laser scribing. The fabrication pitch is about 3 to 10 mm, the number of rectangles is designed in accordance with the design for the size of the glass substrate 1, the output voltage, and the electrode resistance, and the fabrication width is decided. Then, a film as a precursor of an absorption layer 3 is formed by a sputtering method. The film thickness is 1 to 3 µm. When a Cu(In, Ga)Se₂ type absorption layer 3 is formed by gas phase selenization, a multilayered film of a Cu-Ga alloy and In is deposited and then annealing at a temperature of about 500 to 550°C in a hydrogenated Se gas atmosphere to form the absorption layer 3 as shown in the flow of Fig. 8A. As shown in Fig. 8B, it is also possible to use solid phase selenization of depositing also Se together with a metal film by sputtering and then perform annealing subsequently. However, in the case of solid phase selenization, since Se of high vapor pressure tends to evaporate during annealing, it is necessary to prevent evaporating of Se by capping with a buffer layer 4 or a transparent electrode 5.

Successively, an n-type buffer layer 4 is formed by a sputtering method. The film thickness is about 60 nm. As the n-type buffer layer 4, TiO₂ as a base material with addition of ZrO₂, HfO₂, or GeO₂ for band gap control, BaTiO₃ as a base material with addition of SrTiO₃, CaTiO₃, or MgTiO₃ for band gap control, K(Ta, Nb)O₃ as a base material with addition of Na(Ta, Nb)O₃ for band gap control, or a combination of the BiTiO₃ type and K(Ta, Nb)O₃ type materials described above is used. Further, it is also possible to use TiO₂ as a base material and BaTiO₃, SrTiO₃, CaTiO₃, MgTiO₃, K(Ta, Nb)O₃, or Na(Ta, Nb)O₃ as an additive for band gap control within a range of solid solution although the range for control is narrow since crystal structures are different.

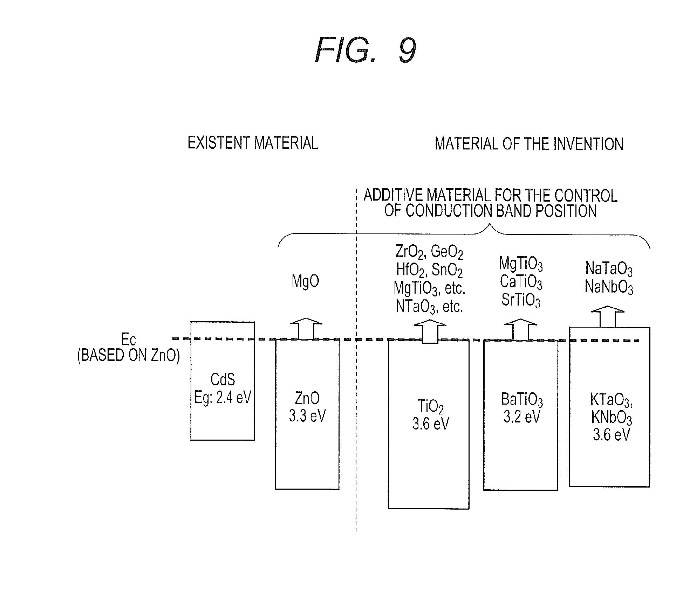

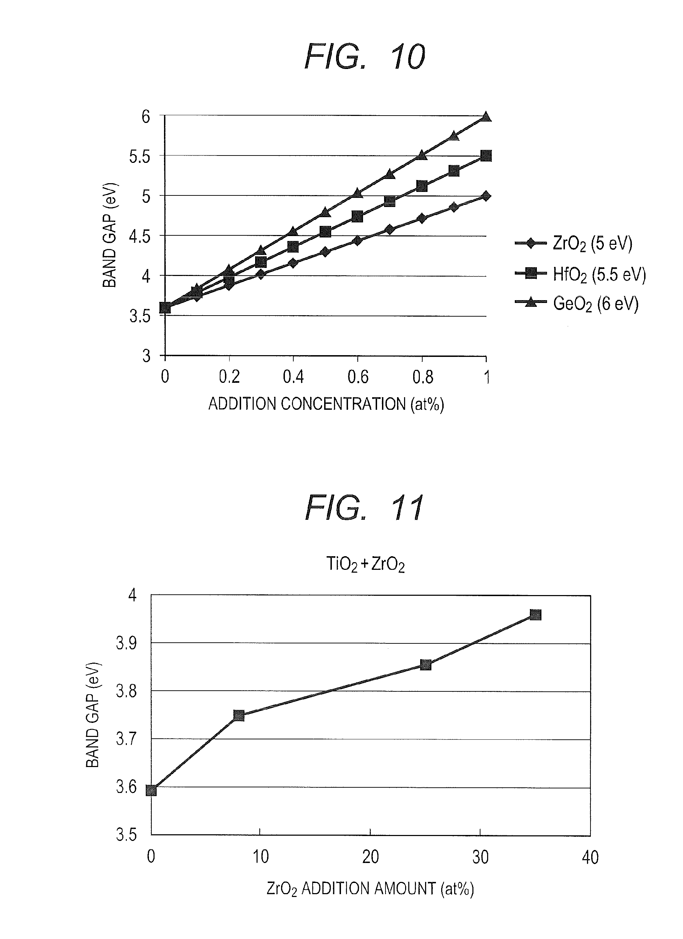

Fig. 9 shows band structures of the materials in comparison with existent CdS and ZnO. Any of the base materials has a wider band gap of 3.2 eV to 3.6 eV compared with CdS and can obtain a transmittance to the solar light equal with or higher than that of ZnO. Further, the band end position Ec of the conduction band is equal with or higher than that of ZnO and the materials have a structure nearer to that of CdS. Further, for the control range of the band gap, while MgO with a band gap of 7.8 eV is added for ZnO, since crystal structure is different between the Wurtzite type ZnO and the rock-salt type MgO, the band gap changes discontinuously (3.9 eV → 4.5 eV) as the concentration of MgO increases to result in a problem that the control range is narrow. On the other hand, in a case of TiO₂, the band gap can be widened continuously to allow matching of the band offset with the conduction band of Cu(In, Ga)Se₂ in a wide range by the addition of GeO₂ at a band gap of 6 eV and having an identical rutile type crystal structure or ZrO₂ at a band gap of 5 eV or HfO₂ at a band gap 5.5 eV and having a similar fluorite type crystal structure. Fig. 10 plots relations between the concentration of the additive materials and the band gap of the buffer layer. In the same manner, BaTiO₃, SrTiO₃, CaTiO₃, MgTiO₃, K(Ta, Nb)O₃, and Na(Ta, Nb)O₃ are also materials of a perovskite structure having a band gap of 3.2 to 4.4 eV and can control the composition without changing the crystal structure and can control the band gap continuously. Further, it is also possible to use TiO₂ as the base material and add a BaTiO₃ type or K(Ta, Nb)O₃ type material so long as the range of the concentration for the additive is within a range of solid solution. Further, Ti or Ta as main constituent of the base material as the buffer layer material is a higher heat resistant and less diffusing compared with Cd or Zn, and can be used for solid phase selenization of performing annealing after forming the buffer layer.

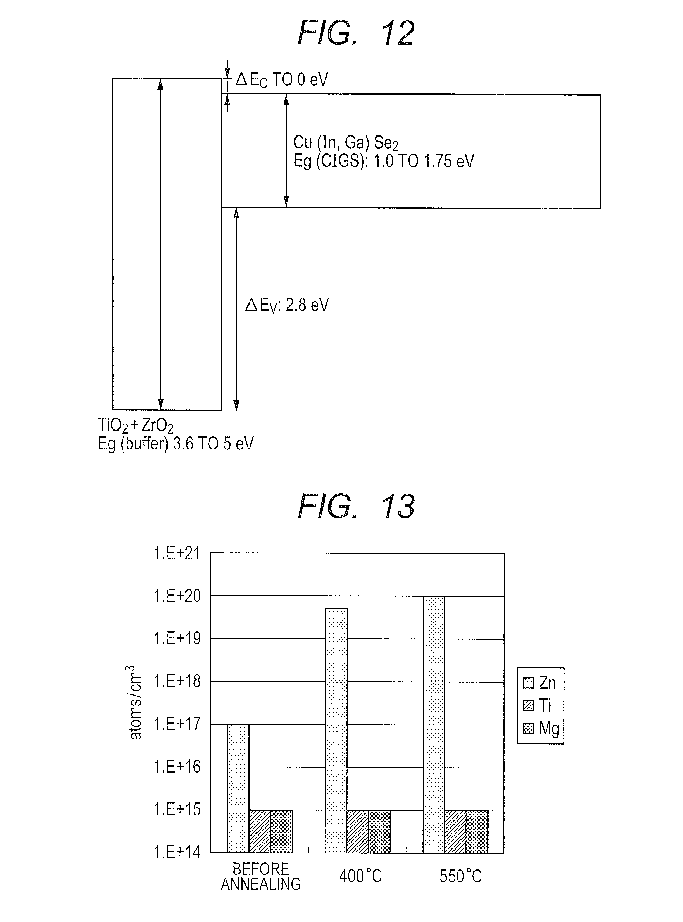

Fig. 11 shows the change of the band gap as measured from spectral transmittance upon addition of ZrO₂ to TiO₂. When the addition amount of ZrO₂ is deflected within a range of more than 0 at% and less than 35 at%, the band gap can be controlled in a range more than 3.6 eV and lower than 3.96 eV and it can be seen that the plotting in Fig. 10 is substantially reproduced. Fig. 12 shows a schematic view of a band structure between a TiO₂ type buffer layer and a Cu(In, Ga)Se₂ type absorption layer. The band offset ΔEc of the conduction band between the buffer layer and the Cu(In, Ga)Se₂ can be determined by subtracting the sum for the band offset ΔEv of the valence band determined by X-ray photoelectron spectrometry (XPS) and the band gap Eg of the Cu(In, Ga)Se₂ type absorption layer (CIGS) determined by the concentration of additive such as Ga from the band gap Eg (buffer) of the buffer layer determined by a spectrophotometer, etc. shown in Fig. 11. Since the band gap Eg of the CuInSe₂ absorption layer (CIGS) with no addition of Ga is about 1 eV, when the addition amount of ZrO₂ to TiO₂ is controlled to 20 at%, ΔEc can be reduced substantially to 0 eV to allow matching. Further, also for the band gap of Cu(In₀.₈, Ga₀.₂)Se₂ at 1.2 eV, ΔEc can be reduced to about 0 eV to allow matching by controlling the addition amount of ZrO₂ to 30 at%. Further, when the band gap of the absorption layer is widened to 1.4 eV or more and 1.75 eV or less in the future, ΔEc can be matched to 0 eV or more and 0.4 eV or less by controlling the addition amount of ZrO₂ to 40 at% or higher and 85 at% or less. In the same manner, ΔEc can be matched to 0 eV or more and 0.4 eV or less to the band gap of the adsorption layer of 1.0 eV or more and 1.75 eV or less by defining the addition amount to 10 at% or more and 65 at% or less in a case of HfO₂ and 10 at% or more and 50 at% or less in a case of GeO₂.

Since the base materials and the additive materials of the invention are materials of higher heat resistance compared with CdS or ZnO, the annealing process for crystallization can be carried out by previously depositing them as a cap on Cu(In, Ga)Se₂ precursor film upon solid phase selenization while capping Cu(In, Ga)Se₂ as described above. When the existent ZnO buffer is used for the cap, since the annealing temperature is restricted to about 400°C for preventing excess diffusion of Zn, crystallization of Cu(In, Ga)Se₂ tends to be insufficient, whereas annealing at 500 to 550°C is possible to crystallize Cu(In, Ga)Sₑ2 sufficiently in a case of using the embodiment of the invention.

Fig. 13 shows a result of measuring, by SIMS, (secondary ion mass spectroscopy) the concentration of Zn, Ti, and Mg in Cu(In, Ga)Se₂ prepared by solid phase selenization by using the ZnO type base material (with addition of MgO) and TiO₂ type base material (with addition of MgTiO₃) as the buffer layer 4 as the cap. While Zn diffuses at a high concentration of 5 × 10¹⁹ to 1 × 10²⁰ atoms/cm³ in Cu(In, Ga) Se₂ by annealing at 400°C or higher, Ti and Mg are scarcely diffused and remain below the sensitivity limit of SIMS (10¹⁵ atoms/cm³).

Accordingly, when ZnO is used, Cu(In, Ga)Se₂ is doped excessively to the n-type and it is difficult to form a good pn junction. However, a good pn heterojunction or a shallow pn homojunction where Mg is slightly diffused into Cu(In, Ga)Se₂ can be formed for a material using TiO₂ as the base material and using MgTiO₃ as the additive even when high temperature annealing is carried out in solid phase selenization.

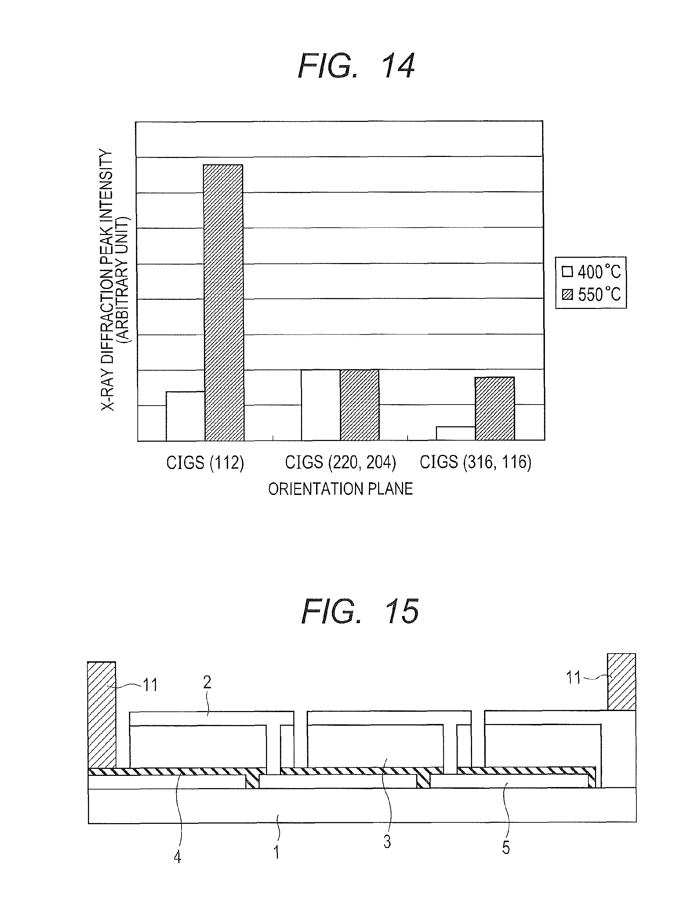

Fig. 14 shows X-ray diffraction peak intensities of Cu(In, Ga) Se₂ crystals annealed at 400°C and 550°C. It can be seen that Cu(In, Ga) Se₂ crystals annealed at 550°C show strong X-ray diffraction peak intensity and high crystallinity.

In a case of the TiO₂ type, since the bivalent elements are not present, only the heterojunction is formed but, in a case of BaTiO₃, SrTiO₃, CaTiO₃, and MgTiO₃, bivalent alkaline earth metals are substitution elements for Cu in Cu(In, Ga)Se₂ and can form a pn homojunction in Cu(In, Ga)Se₂. Particularly, since the radius of 4 coordination ion Mg²⁺ (0.57 Å) is close to the radius of 4 coordinate ion CU¹⁺ (0.60 Å) in Cu(In, Ga)Se₂ of chalcopyrite crystals, MnTiO₃ are an optimal substitution material and can form a good homojunction. Further, Na in Na (Ta, Nb)O₃ has an effect of enhancing the crystallinity of Cu(In, Ga)Se₂ by diffusion (Na effect). Then, the buffer layer 4 and the absorption layer 3 are fabricated each into a rectangular shape on the Mo back electrode 2 by mechanical scribing. Since the absorption layer 3 comprises a material softer than MO, the absorption layer 3 and the buffer layer 4 can be fabricated without damaging the underlying Mo back electrode 2 by properly keeping the fabrication pressure upon mechanical scribing.

Then, a transparent electrode 5 is formed by a sputtering method. As the transparent electrode 5, AZO, GZO, and BZO each comprising ZnO and with addition of Al, Ga, and B, respectively can be used for instance. In addition, ITO, IZO, FTO or ATOeach comprising SnO₂ and with addition of F and Sb respectively can be used for instance. After deposition, the transparent electrode 5, the buffer layer 4, and the absorption layer 3 are fabricated by mechanical scribing. By the step, compound thin film solar cells in serial connection can be formed. Further, after printing collector lines 11 at the panel end face 3, a substrate type compound thin film solar cell module can be formed by sealing with a cover glass 8 and a back sheet 9 by way of a sealing resin 7 such as EVA (Ethylene Vinyl Acetate) as shown in Fig. 5.

As described above, by using the embodiment of the invention, it is possible to provide a material for the buffer layer with no toxicity, having a large wide band gap of 3 eV or more, capable of controlling the band gap width and matching for the band offset of the conduction band with the absorption layer 3, and having good insulation property and high transmittance to the solar spectrum. Further, in the existent materials of buffer layer, the buffer layer has to be deposited by using the CBD method at low temperature after annealing in hydrogenated Se of high toxicity (gas phase selenization), and this results in a problem in view of the cost for ensuring the safety of the annealing apparatus for gas phase selenization and lowering of the throughput upon mass production due to the combined use of the dry process such as sputtering deposition and the wet process of the CBD method. On the other hand, in the invention, deposition is always carried out by sputtering, and it is possible to use the process of solid phase selenization that does not require annealing in highly toxic hydrogenated Se, thereby enabling to simplify the process and reduce the cost.

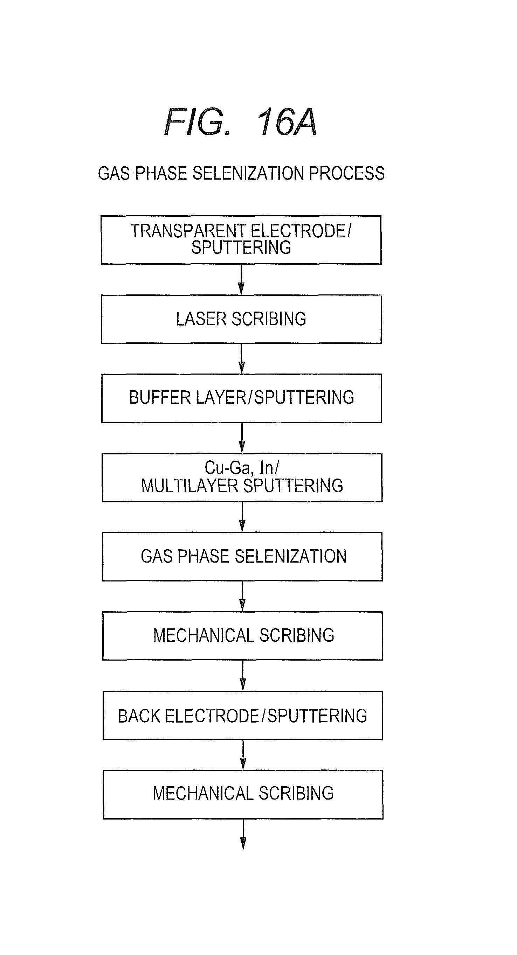

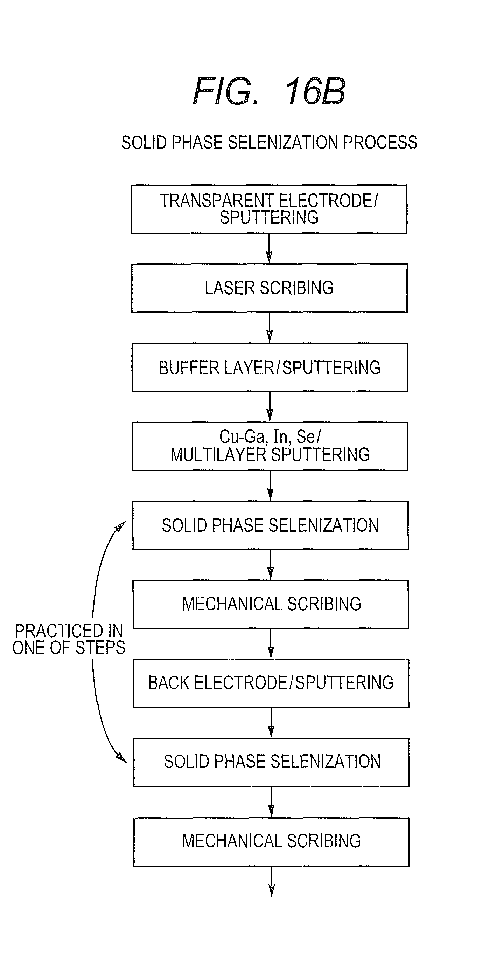

Then, a method of preparing a superstrate type compound thin film solar cell module as a second embodiment of the invention is to be described specifically with reference to the structural view of Fig. 15 and the process flow charts of Figs. 16A and 16B. In this embodiment, white semi-tempered glass usually used for cover glass is used as a glass substrate 1. Then, a transparent electrode film 5 is formed by a sputtering method. As the transparent electrode 5, for example, AZO, GZO, or BZO each comprising ZnO and with addition of Al, Ga, or B respectively, ITO, IZO, or FTO or ATO each comprising SnO₂ with addition of F or Sb, respectively, can be used. Then, the film of the transparent electrode 5 is fabricated into a rectangular shape by using laser scribing or the like. The fabrication pitch is about 3 to 10 mm, the number of rectangles is designed in accordance with the design for the size of the glass substrate 1, the output voltage, and the electrode resistance, and the fabrication width is decided.

Successively, an n-type buffer layer 4 and a precursor film of an absorption layer 3 are deposited. The n-type buffer layer 4 uses a material, for example, comprising TiO₂ as a base material with addition of ZrO₂, HfO₂, GeO₂, etc. for band gap control, BaTiO₃ as a base material with addition of SrTiO₃, CaTiO₃, or MgTiO₃ for band gap control, K(Ta, Nb)O₃ as a base material with addition of Na(Ta, Nb)O₃ for band gap control, or TiO₂ as a base material in combination with one or plurality of BaTiO₃ type, K(Ti, Nb)O₃ type materials as the additive. The precursor film for the absorption layer 3 is also formed by the sputtering method. The film thickness is from 1 to 3 µm. When the Cu(In, Ga)Se₂ type absorption layer 3 is formed by gas phase selenization, a multilayer film of a Cu-Ga alloy and In is deposited and, subsequently, annealed in a hydrogenated Se gas atmosphere at a temperature of about 500 to 550°C as shown in Fig. 16A, to form an adsorption layer. As shown in Fig. 16B, solid phase selenization can also be used by also depositing Se together with a metal film by sputtering and then annealing them. In this case, the precursor film of the absorption layer 3 and the buffer layer 4 are fabricated by mechanical scribing, etc., then Mo is deposited as the back electrode 2 and annealing is carried out for crystallization in an inert gas while capping by Mo. Since each of the materials of the buffer layer 4 of the invention has higher heat resistance compared with CdS or ZnO, and does not diffuse excessively during the annealing process for crystallization as described above, it is possible to make the annealing temperature sufficiently high and the crystallinity of Cu(In, Ga)Se₂ can be enhanced. Further, it is also possible to protect the transparent electrode 5 and prevent increase of the resistivity of the transparent electrode.

Since the cell structure is a superstrate structure in which the glass substrate 1 is on the light incident side, modulation is attained by merely bonding the glass substrate 1 and the back sheet 9 by way of the EVA sheet 7 to each other as shown in Fig. 6 without requiring the cover glass 8. Accordingly, it is possible to save the number of parts and reduce the cost compared with the existent Cu (In, Ga)Se₂ compound thin film solar cell module.

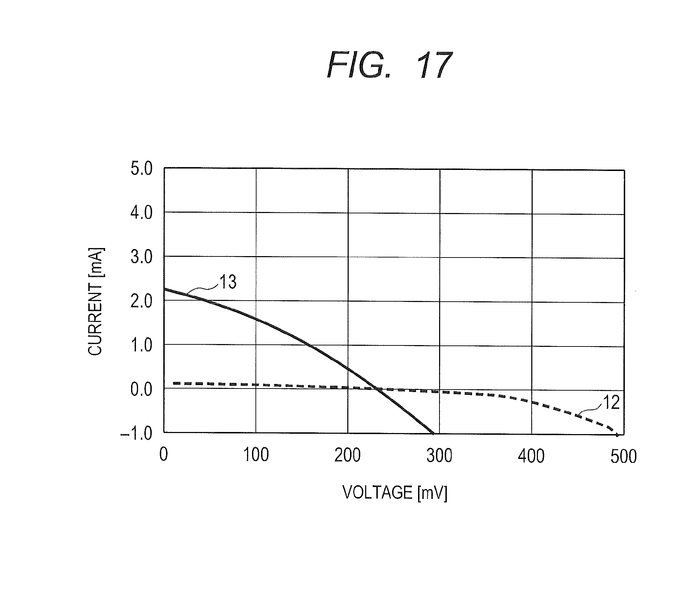

A third embodiment is to be described. Control of the band gap by adding other oxides to the base material of n-type TiO₂ has been disclosed above. Generally, the n-type oxide semiconductor such as TiO₂ shows an n-type semiconductor property due to slight deficiency of oxygen in the crystals. Usually, n-type TiO₂ can be deposited by sputtering deposition in an Ar atmosphere. In the first embodiment or the second embodiment, sputtering deposition has been performed in a pure Ar atmosphere with no addition of oxygen. However, when sputtering deposition is performed in an Ar atmosphere with a considerable amount of remaining oxygen or an Ar atmosphere with intentional addition of oxygen, since the position of the Fermi level shifts toward the center of the band gap and the valence electron band offset 6v to the semiconductor absorption layer also changes sometimes, the conduction band offset 6c does not always take a desired value. Fig. 17 shows a current-voltage curve 12 in a buffer layer using TiO₂ prepared under such a condition. As a result of analysis for the band arrangement in the hetero-junction of TiO₂ and CIGS semiconductors, it has been found that the carrier concentration is 10¹⁵ cm⁻³ and the conduction band offset is 0.6 eV.

The present inventor has experimentally found that a further larger photogenerated current can be obtained not relying on oxygen deficiency but providing TiO₂ with electroconductivity by substituting 4-valent Ti with 5-valent element. The current-voltage curve 13 in Fig. 17 in a case of doping Nb by 10% to a buffer layer using TiO₂ shows a power generation property when Nb is doped by 10% to TiO₂ thereby obtaining n-conduction type. As can be seen from the curve, the conduction band offset ΔEc is lowered by addition of Nb and the photogenerated current can take a further larger value to improve the power generation property. The band gap of the CIGS semiconductor in this case is 1.06 eV.

Then, the addition amount of Nb is to be referred to. When Nb is doped at a high concentration to TiO₂ to form a degenerate semiconductor in a metal state, this transfers from a semiconductor hetero-junction to a metal-semiconductor junction. In this case, when the carrier concentration is, for example, at 10¹⁹ cm⁻³, the conduction band offset is estimated as -0.25 eV. That is, the conduction band offset shows +0.6 eV when TiO₂ is in the state of an insulator and shows -0.25 eV when it is a degenerate semiconductor in the state of metal. In an intermediate state between them, that is, when the carrier concentration is 10¹⁵ cm⁻³ or more and 10¹⁹ cm^{**-**3} or less, ΔEc takes a value of -0.25 eV or more and +0.6 eV or less.

The upper limit of the carrier concentration is preferably in a range not causing degeneration. When the concentration is so high as causing degeneration, TiO₂ transforms into the metal state and the conduction band offset has a large negative value. Accordingly, the carrier concentration is preferably 10¹⁸ cm⁻³ or less. Further, the thickness of the buffer layer may be controlled generally in accordance with the carrier concentration, that is, the thickness may be larger when the carrier concentration is higher and smaller when the concentration is lower. Specifically, the thickness may be controlled such that the conversion efficiency is at the maximum level within a range of 10 nm or more and 300 nm or less.

While Nb has been used as the dopant to TiO₂ in this case, the same effect can be expected also by using other element belonging to the group VA of the periodical table such as vanadium V or tantalum Ta. Also in this case, the carrier concentration is preferably 10¹⁵ cm⁻³ or more and 10¹⁹ cm⁻³ or less in the same manner. However, it is considered that Nb having an ionic radius close to that of Ti is most preferred since the electric activity is high.

The invention is effective when applied to the Cu(In, Ga)Se₂ type compound thin film solar cell and module and can be utilized generally in the industrial field of power generation solar cell for the use of residential houses and mega-solar facilities.

The above embodiments of the invention as well as the appended claims and figures show multiple characterizing features of the invention in specific combinations. The skilled person will easily be able to consider further combinations or sub-combinations of these features in order to adapt the invention as defined in the in the claims to his specific needs.

## Claims

1. A compound thin film solar cell including a substrate (1), a transparent electrode (5), a compound thin film semiconductor (3) disposed between the substrate (1) and the transparent electrode (5), a back electrode (2) disposed between the substrate (1) and the compound thin film semiconductor (3), and an n-type buffer layer (4) disposed between the transparent electrode (5) and the compound thin film semiconductor (3), in which the n-type buffer layer (4) contains one or plurality of TiO₂, BaTiO₃, and K(Ta, Nb)O₃.

2. The compound thin film solar cell according to claim 1, wherein the n-type buffer layer (4) contains Ti0₂ with further addition of one or plurality of ZrO₂, HfO₂, GeO₂, BaTiO₃, SrTiO₃, CaTiO₂, MgTiO₃, K(Ta, Nb)O₃, and Na(Ta, Nb)O₃.

3. The compound thin film solar cell according to claim 1 or 2, wherein the band gap of the compound thin film semiconductor (3) is 1 eV or more and 1.75 eV or less, and ZrO₂ is added by 20 at% or more and 85 at% or less to TiO₂.

4. The compound thin film solar cell according to one of claims 1-3, wherein the band gap of the compound thin film semiconductor (3) is 1 eV or more and 1.75 eV or less, and HfO₂ is added by 10 at% or more and 65 at% or less to TiO₂.

5. The compound thin film solar cell according to one of claims 1 - 4, wherein the band gap of the compound thin film semiconductor (3) is 1 eV or more and 1.75 eV or less, and GeO₂ is added by 10 at% or more and 50 at% or less to TiO₂.

6. The compound thin film solar cell according to one of claims 1 - 5, wherein the n-type buffer layer (4) contains BaTiO₃ with further addition of one or plurality of SrTiO₃, CaTiO₃, and MgTiO₃.

7. The compound thin film solar cell according to one of claims 1 - 6, wherein the n-type buffer layer (4) contains K(Ta, Nb)O₃ with further addition of Na(Ta, Nb)O₃.

8. The compound thin film solar cell according to one of the preceding claims, wherein the n-type buffer layer (4) contains TiO₂ with further addition of a group VA element of the periodical table.

9. The compound thin film solar cell according to claim 8, wherein the group VA element of the periodical table contains Nb.

10. The compound thin film solar cell according to claim 8, wherein the group VA element of the periodical table contains one or plurality of Va and Ta.

11. The compound thin film solar cell according to claim 9, wherein the carrier concentration of the n-type buffer layer (4) is 10¹⁵ cm⁻³ or more and 10¹⁹ cm⁻³ or less.

12. A compound thin film solar cell module including a back sheet, a first sealing resin, a substrate (1), a back electrode (2), a compound thin film semiconductor (3), an n-type buffer layer (4), a transparent electrode (5), a second sealing resin, and a cover glass laminated in this order, or a back sheet, a sealing resin, a back electrode (2), a compound thin film semiconductor (3), an n-type buffer layer (4), a transparent electrode (5), and a substrate (1) laminated in this order and, further, including current collection lines, in which the n-type buffer layer (4) contains one or plurality of TiO₂, BaTiO₃, and K(Ta, Nb)O₃.

13. The compound thin film solar cell module according to claim 12, wherein the n-type buffer layer (4) contains Ti0₂ with addition of one or plurality of ZrO₂, HfO₂, GeO₂, BaTiO₃, SrTiO₃, CaTiO₃, MgTiO₃, K(Ta, Nb)O₃, and Na(Ta, Nb)O₃.

14. The compound thin film solar cell module according to claim 12 or 13, wherein the n-type buffer layer (4) contains BaTiO₃ with addition of one or plurality of SrTiO₃, CaTiO₃, and MgTiO₃.

15. The compound thin film solar cell module according to claim 12, 13 or 14, wherein the n-type buffer layer (4) contains K(Ta, Nb)O₃, with addition of Na(Ta, Nb)O₃.

16. The compound thin film solar cell according to one of claims 12 - 15, wherein the n-type buffer layer (4) contains TiO₂ with further addition of a group VA element of the periodical table.

17. A method of manufacturing a compound thin film solar cell including the steps of forming a substrate (1), forming a back electrode (2), forming a compound thin film semiconductor (3), forming a transparent electrode (5), and forming an n-type buffer layer (4) containing one or plurality of TiO₂, BaTiO₃, and K (Ta, Nb)O₃, wherein
solid Se is incorporated into a precursor film of the compound thin film semiconductor (3) in the step of forming the compound thin film semiconductor (3), and the compound thin film semiconductor (3) is crystallized by an annealing treatment while capping the precursor film with the n-type buffer layer (4) or the back electrode (2)
and/or wherein
the step of forming the compound thin film semiconductor (3) includes the step of performing annealing in a hydrogenated Se gas atmosphere.

18. The method of manufacturing a compound thin film solar cell according to claim 17, wherein the step of forming the back electrode (2) is carried out prior to the step of forming the compound thin film semiconductor (3).

19. The method of manufacturing a compound thin film solar cell according to claim 17 or 18, wherein the step of forming the transparent electrode (5) is carried out prior to the step of forming the n-type buffer layer (4) and the step of forming the n-type buffer layer (4) is carried out prior to the step of forming the compound thin film semiconductor (3).
